Europäisches Patentamt

European Patent Office

Office européen des brevets

(19)

(11) Publication number: **0 154 360**

A1

(12) **EUROPEAN PATENT APPLICATION**

(21) Application number: 85200101.5

(22) Date of filing: 34.01.85

(51) Int. Cl.⁴: **G 01 N 24/04**
**G 01 N 24/08**

(30) Priority: **03.02.84 NL 8400327**

(43) Date of publication of application:
**11.09.85 Bulletin 85/37**

(84) Designated Contracting States:
**DE FR GB**

(71) Applicant: **N.V. Philips' Gloeilampenfabrieken**
**Groenewoudseweg 1**
**NL-5621 BA Eindhoven(NL)**

(72) Inventor: **Grimbergen, Henricus Adrianus Antonius**
**c/o INT. OCTROOIBUREAU B.V. Prof. Holstlaan 6**
**NL-5656 AA Eindhoven(NL)**

(72) Inventor: **Booyen, Paul Edwin**
**c/o INT. OCTROOIBUREAU B.V. Prof. Holstlaan 6**
**NL-5656 AA Eindhoven(NL)**

(74) Representative: **Scheele, Edial François et al,**
**INTERNATIONAAL OCTROOIBUREAU B.V. Prof.**
**Holstlaan 6**
**NL-5656 AA Eindhoven(NL)**

(54) Coil for nuclear mangnetic resonance apparatus.

(57) A measurement excitation coil for producing a radio-frequency field and for measuring nuclear magnetic resonance signals, respectively, in which the shape of a single tubular current conductor is adapted to the shape of objects normally to be measured. In order to avoid field disturbance *in situ,* the supply and return leads are arranged radially beside each other.

FIG.1

EP 0 154 360 A1

Coil for nuclear magnetic resonance apparatus.

The invention relates to an excitation and/or measurement coil for a nuclear magnetic resonance apparatus for producing a radio-frequency electromagnetic field in a measurement space and for detecting nuclear magnetic resonance signals to be generated by an object under examination in the measurement space.

Such a radio-frequency coil is known from European Patent Application EP 0086560 and is indicated therein as an element F or 28.

In the case of the saddle coil described therein, which is the most suitable type of coil for many applications in nuclear magnetic resonance apparatus, disadvantages occur in practice. Thus, such a coil often leads to patients suffering a feeling of discomfort due to the fact that the space inside it is comparatively restricted. Furthermore, the Q value of known coils for use at the usual measurement frequencies, is comparatively low and frequently depends rather closely on the quantity of substance present in the measurement coil, as a result of which the coil has to be retuned in accordance with the object to be measured. Moreover, a re-alignment of such a coil can often be effected only with comparatively great difficulty, while in the measurement arrangement the space for treating a patient can become insufficient.

The invention has for its object to obviate these disadvantages and according to the invention a radio-frequency coil of the kind mentioned in the opening paragraph is for this purpose characterized in that the coil is composed of a single self-supporting conductor having a comparatively low electrical resistance, whose shape is adapted to the shape of objects to be measured, and in that the coil can be mounted in the measurement space of a nuclear magnetic resonance apparatus so as to be displaceable as a whole.

Due to the fact that the coil according to the invention is made so as to be antirely self-supporting, it can be readily displaced in a measurement space, as a result of which, if desired, before each image exposure the position can be adapted to the object to be measured.

In a preferred embodiment, the current conductor has a slightly triangular form at the area at which it extends in a cross-sectional plane with respect to the main magnet of a nuclear magnetic resonance apparatus, as a result of which fewer problems occur when a patient is introduced into the measurement space, and a coil having a higher Q value and a higher measurment sensitivity is provided.

In a further preferred embodiment, the supply leads, viewed in the rotation-symmetrical magnetic field, are arranged radially beside one an other, as a result of which less disturbance occurs in situ to the radio-frequency field and therefore also to the measurement signal.

In a further embodiment, the current conductor consists entirely of a single preferably tubular conductor. Preferably, an electrical screen is arranged to surround the current conductor with the interposition of spacer rings.

A few preferred embodiments according to the invention will now be described more fully with reference to the drawing. In the drawing:

Figure 1 shows a coil according to the invention composed of a single tubular electrical conductor, and

Figure 2 shows a schematic circuit diagram for tuning and feeding such a coil.

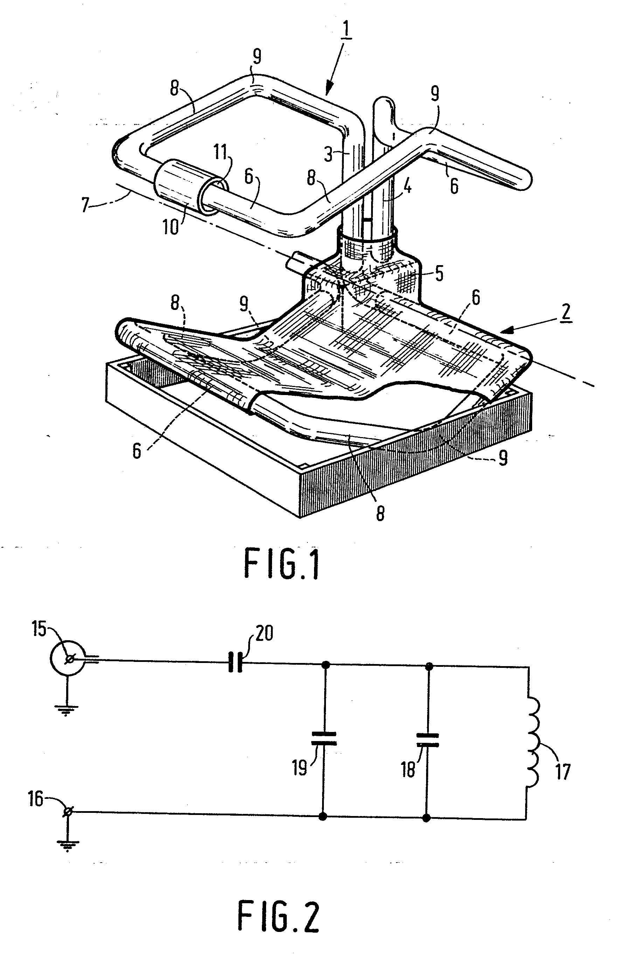

A measurement detection coil of the kind shown in Figure 1 comprises a first half formed by a saddle coil 1, a second half formed by a saddle coil 2, supply leads 3 and 4 and a control adjustment device 5. When mounting the coil in a measurement space within a main magnet for producing a uniform magnetic field parallel to an axis of rotation 7 of the system, straight portions 6 of the coil turns usually also extend parallel to the direction of the main magnetic field Ho. Each of the end conductor portions 8 of similar shape has, as a departure from the uasual arcuate form, a slightly triangular form, as a result of which a larger amount of free space is provided for patients in a plane through the four apices of the triangles. In an optimized embodiment, the conductor consits of a circular tube having an outer diameter of, for example, 25 mm and a wall thickness of 1 to 2 mm. As a result, a lower electrical resistance is provided by a readily deformable and satisfactorily self-supporting conductor. The conductors can be deformed by the methods commonly used for this purpose. It should then be ensured that no irregularities or cracks occur in the tube material.

For safety considerations it is desirable to screen the conductor from the coil by an electrical screen 10 shown in part, while it should be ensured that the screening material could not make contact with the conductor. It is therefore generally favourable to arrange the screening around the conductor with an interstice 11, which can be realized, for example, by means of a few supporting space rings.

Measurements have shown that with such a coil loaded by 50 $\Omega$ for usual frequencies up to, for example. 6 MHz a Q value to, for example, 200 can be obtained, as a result of which an improvement of the signal-to-noise ratio in the measurement signals is achieved. In the unloaded condition, the coil yields for the said frequency a Q value of 400. Due to the self-supporting character of the coil, the coils can be made simple to exchange, as a result if which the coil can be adapted to the patient or to the body part of the patient to be examined or to another object to be examined or to the frequency to be used, while furthermore some treatment can be applied to a patient arranged in the coil.

Figure 2 shows a schematic circuit diagram of a connecting circuit for the coil for the purpose of tuning, feeding and signal detection. A supply generator or a signal detector can be connected to the terminals 15 and 16. Two capacitors 18 and 19 are connected parallel to the coil, which in this case is indicated as an inductor 17, while a capacitor 20 is connected in series therewith. The inductance of the coil is, for example, about 1.5 $\mu$H; the capacitance values of the capacitor 18 and of the capacitors 19 and 20 are about 300 pF and, for example, 120 pF, respectively. The tuning and matching capacitances are arranged in parallel for the resonance frequency; in the given example, the overall capacitance becomes 300 + 120 + 120 = 540 pF, which together with the inductance L=1.5 $\mu$H leads to a resonance frequency of about 6 MHz. The capacitance values of the capacitors 19 and 20 are adjustable. Each of these capacitors can be independently adjustable, but it is also possible for them to be simultaneously adjustable, in which event for an optimum adjustment the capacitor 18 can also be controlled. A more symmetrical form of tuning can be provided by connecting an additional capacitor between the capacitor 19 and the connection terminal 16, which is adjustable simultaneously with the capacitors 19 and 20 in a manner such that the sum of the capacitances 19 and 20 is constant. A symmetrical form of construction can also be provided by connecting the terminal 16 to a tapping point on the coil, the capacitors 18 and 19 being connected across the coil 17.

PHN 10.926 5 201-54360

Claims:

CLAIMS

1. An excitation and/or measurement coil for producing a radio-frequency electromagnetic field in a nuclear magnetic resonance apparatus and for detecting nuclear magnetic resonance signals to be produced in an object to be measured, characterized in that the coil is composed of a single self-supporting conductor having a low resistance, whose shape is adapted to the shape of objects to be measured and which is displaceable in a measurement space of the nuclear magnetic resonance apparatus.

2. An excitation and/or measurement coil as claimed in Claim 1, characterized in that the respective conductor portions in each transverse end plane of a magnetic measurement field each substantially forms two sides of a rounded triangle.

3. An excitation and/or measurement coil as claimed in Claim 1 or 2, characterized in that it is composed of a single bent tubular current conductor.

4. An excitation and/or measurement coil as claimed in any one of the preceding Claims, characterized in that the conductor is provided with an electrical screening which is not in contact with the conductor.

5. An excitation and/or measurement coil as claimed in any one of the preceding Claims, characterized in that it is mounted on a carriage displaceable in a measurement space.

6. An excitation and/or measurement coil as claimed in any one of the preceding Claims, characterized in that supply and return leads for the coil, are arranged, viewed in a transverse sectional plane, beside each other.

7. A nuclear magnetic resonance apparatus provided with an excitation and/or measurement coil as claimed in any one of the preceding Claims.

0154360

FIG.1

FIG.2

PHN 10926

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| A | DE-A-3 323 657 (INSTRUMENTARIUM OY) * Page 1, line 1 - page 2, line 7; page 10, lines 13-22; page 13, lines 9-22; page 16, lines 5-21 * | 1,3 | G 01 N 24/04 G 01 N 24/08 |
| A | EP-A-0 073 375 (SIEMENS AG) * Page 6, line 10 - page 8, line 36 * | 1,4 | |
| A | GB-A-2 052 753 (EMI LTD.) * Page 4, lines 73-101; figure 7 * | 1 | |
| A | GB-A-2 056 086 (EMI LTD.) * Page 2, lines 26-48, 75-98; figure 1 * | 1 | TECHNICAL FIELDS SEARCHED (Int. Cl.4) |
| A | WO-A-8 400 214 (OXFORD RESEARCH SYSTEMS, LTD.) * Page 2, line 13 - page 5, line 2; figures 3,4,9 * | 1 | G 01 N 24/00 |
| A | US-A-4 411 270 (R.V. DAMADIAN) * Column 9, line 26 - column 10, line 10; figures 8,13 * | 1 | |
| A,D | EP-A-0 086 560 (TECHNICARE CORP.) .* Page 6, line 20 - page 7, line 22 * | 1 | |

The present search report has been drawn up for all claims

| Place of search | Date of completion of the search | Examiner |
|---|---|---|
| THE HAGUE | 10-05-1985 | HORAK G.I. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82